# EUROPÄISCHE PATENTSCHRIFT

(11) **EP 3 259 783 B1**
(45) Veröffentlichungstag und Bekanntmachung des Hinweises auf die Patenterteilung: **05.06.2019**
(21) Anmeldenummer: 16703789.4
(22) Anmeldetag: 10.02.2016
(51) Int. Cl.: H01L 29/06, H01L 33/38, H01L 33/44

(54) **VERFAHREN ZUR HERSTELLUNG EINES HALBLEITERKÖRPERS**
METHOD FOR PRODUCING A SEMICONDUCTOR BODY
PROCÉDÉ DE FABRICATION D'UN CORPS À SEMI-CONDUCTEUR

(30) Priorität: 19.02.2015 DE 102015102374
(43) Veröffentlichungstag der Anmeldung: 27.12.2017
(73) Patentinhaber: OSRAM Opto Semiconductors GmbH, 93055 Regensburg (DE)
(72) Erfinder: EBERHARD, Franz, 93059 Regensburg (DE)
(74) Vertreter: Epping - Hermann - Fischer
(86) Internationale Anmeldenummer: PCT/EP2016/052817
(87) Internationale Veröffentlichungsnummer: WO 2016/131690

(56) Entgegenhaltungen:
- CN-U- 202 094 125
- US-A1- 2013 210 178

## Beschreibung

Es wird ein Verfahren zur Herstellung eines Halbleiterkörpers mit einer Ausnehmung angegeben.

Diese Patentanmeldung beansprucht die Priorität der deutschen Patentanmeldung 10 2015 102 374. 1.

Um eine mit einer oder mehreren weiteren Halbleiterschichten bedeckte Halbleiterschicht einer Halbleiterschichtenfolge zu kontaktieren, können eine oder mehrere Durchkontaktierungen, so genannten Vias, verwendet werden, die durch die bedeckenden Halbleiterschichten hindurch zur zu kontaktierenden Halbleiterschicht reichen. Hierbei handelt es sich üblicherweise um Öffnungen in der Halbleiterschichtenfolge in Form von Sacklöchern, die durch einen Teil der Halbleiterschichtenfolge hindurch ragen und die mit einem elektrisch leitenden Material gefüllt sind. Um zu vermeiden, dass eine Durchkontaktierung die durchragten Halbleiterschichten kurzschließt, werden üblicherweise die Seitenflanken der Öffnungen, in denen Durchkontaktierungen angeordnet sind, mit einer elektrisch isolierenden Schicht versehen, so dass die Durchkontaktierung innerhalb der Halbleiterschichtenfolge lediglich mit der zu kontaktierenden Halbleiterschicht in elektrischem Kontakt steht. Zur besseren Kontaktierung des die Öffnungen füllenden Materials können die Öffnungen vor dem Füllen mit Kontaktschichten versehen werden.

Zur Herstellung einer Durchkontaktierung ist somit zum einen eine Öffnung in der Halbleiterschichtenfolge herzustellen. Zum anderen ist die Öffnung mit einer elektrisch isolierenden Schicht und einer Kontaktschicht zu versehen, wobei derjenige Teil der Öffnung, in dem die Kontaktschicht angeordnet ist, zumindest teilweise frei von der elektrisch isolierenden Schicht sein muss. Hierzu werden im Stand der Technik üblicherweise mehrere Fotolackmasken in zwei oder mehr getrennten Fotoebenen verwendet. Das bedeutet, dass verschiedene Fotolackmasken nacheinander zur Herstellung der Öffnungen in der Halbleiterschichtenfolge, zur Strukturierung der elektrisch isolierenden Schicht und zur Strukturierung der Kontaktschicht verwendet werden. Dies erfordert jedoch eine äußerst genaue und damit aufwändige Prozessführung.

Dokument CN 202094125 offenbart eine LED-Vorrichtung, wobei die Lichtemissionsregionen durch einen unterätzten Bereich getrennt sind.

Zumindest eine Aufgabe von bestimmten Ausführungsformen ist es, ein Verfahren zur Herstellung eines Halbleiterkörpers anzugeben, der zumindest eine mit einer Kontaktschicht versehene Ausnehmung aufweist.

Diese Aufgabe wird durch ein Verfahren gemäß dem unabhängigen Patentanspruch gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Gemäß zumindest einer Ausführungsform wird ein Verfahren zur Herstellung eines Halbleiterkörpers angegeben. Insbesondere kann es sich bei dem Verfahren um einer Verfahren zur Herstellung eines Halbleiterkörpers mit zumindest einer mit einer Kontaktschicht versehenen Ausnehmung handeln. Weiterhin kann es sich um ein Verfahren handeln, bei dem die zumindest eine Ausnehmung mit einer Passivierungsschicht versehen wird.

Gemäß einer weiteren Ausführungsform wird ein Halbleiterkörper bereitgestellt. Der Halbleiterkörper kann eine oder mehrere Halbleiterschichten aufweisen, die bevorzugt eine Halbleiterschichtenfolge bilden und die durch ein epitaktisches Aufwachsverfahren auf einem Aufwachssubstrat aufgebracht werden können. Beispielsweise kann es sich bei dem Halbleiterkörper um eine Halbleiterschichtenfolge handeln, die zur Herstellung von optoelektronisch aktiven Halbleiterchips, beispielsweise Licht emittierenden oder Licht absorbierenden Halbleiterchips, vorgesehen ist. Hierzu kann der Halbleiterkörper eine Halbleiterschichtenfolge mit zumindest einem optoelektronisch aktiven Bereich, insbesondere einen Licht emittierenden oder Licht detektierenden Bereich, aufweisen, der zwischen weiteren Halbleiterschichten, die voneinander verschiedene Leitungstypen aufweisen können, angeordnet ist. Alternativ dazu kann es sich bei dem Halbleiterkörper auch um einen nicht-optoelektronisch aktiven Halbleiterkörper handeln. Beispielsweise kann der Halbleiterkörper zur Herstellung von elektronischen Halbleiterchips wie beispielsweise Transistoren oder anderen elektronischen Bauelementen vorgesehen sein. Der Halbleiterkörper kann auf einem Trägerelement, das ein Aufwachssubstrat oder ein von einem Aufwachssubstrat verschiedenes Trägersubstrat sein kann, bereitgestellt werden.

Der Halbleiterkörper kann beispielsweise auf einem Verbindungshalbleitermaterialsystem, insbesondere einem III-V-Verbindungshalbleitersystem, basieren und Halbleiterschichten aufweisen, die ein Arsenid-, Phosphid- und/oder Nitrid-Verbindungshalbleitermaterial aufweisen.

Alternativ hierzu sind auch andere Halbleitermaterialien denkbar, beispielsweise II-VI-Verbindungshalbleitermaterialien, Silizium-basierte Halbleitermaterialien oder Germanium-basierte Halbleitermaterialien.

Gemäß einer weiteren Ausführungsform wird auf dem Halbleiterkörper eine erste Maskenschicht aufgebracht. Insbesondere kann der Halbleiterkörper im Hinblick auf seine Herstellung in Form einer oder mehrerer Halbleiterschichten eine Aufwachsrichtung aufweisen, so dass der Halbleiterkörper in Aufwachsrichtung mit einer Hauptoberfläche abschließt. Die erste Maskenschicht kann insbesondere auf der in Aufwachsrichtung abschließenden Hauptoberfläche, die senkrecht zur Aufwachsrichtung sein kann, angeordnet werden.

Insbesondere kann es sich bei der ersten Maskenschicht um eine Lackmaske handeln, also insbesondere um einen Fotolack. Die erste Maskenschicht wird strukturiert mit zumindest einer ersten Maskenöffnung aufgebracht. Die zumindest eine erste Maskenöffnung liegt in dem Bereich, in dem im Halbleiterkörper die zumindest eine Ausnehmung ausgebildet werden soll. Insbesondere kann die erste Maskenschicht eine oder eine Mehrzahl von ersten Maskenöffnungen in dem oder den Bereichen aufweisen, in dem oder denen eine oder eine Mehrzahl von Ausnehmungen im Halbleiterkörper ausgebildet werden sollen. Zur Herstellung der zumindest einen ersten Maskenöffnung in der ersten Maskenschicht kann die erste Maskenschicht beispielsweise großflächig auf der Hauptoberfläche des Halbleiterkörpers aufgebracht und anschließend unter Verwendung eines geeigneten Belichtungsprozesses zur Herstellung der zumindest einen ersten Maskenöffnung strukturiert werden.

Gemäß einer weiteren Ausführungsform wird auf dem Halbleiterkörper eine zweite Maskenschicht aufgebracht. Insbesondere wird die zweite Maskenschicht zwischen der ersten Maskenschicht und dem Halbleiterkörper aufgebracht. Das bedeutet mit anderen Worten, dass auf dem Halbleiterkörper zuerst die zweite Maskenschicht und auf dieser dann die erste Maskenschicht aufgebracht wird. Die zweite Maskenschicht wird insbesondere unstrukturiert und großflächig aufgebracht, also insbesondere ohne eine Öffnung im Bereich der zumindest einen ersten Maskenöffnung der ersten Maskenschicht. Zum Aufbringen der zweiten Maskenschicht kann somit ein nicht strukturierendes, großflächiges Verfahren ohne Einsatz einer Maske verwendet werden. Das Aufbringen der ersten Maskenschicht erfolgt somit auf der großflächig und unstrukturiert aufgebrachten zweiten Maskenschicht. Bei der zweiten Maskenschicht kann es sich insbesondere um eine Hartmaske handeln. Beispielsweise kann die zweite Maskenschicht ein Oxid oder ein Oxinitrid, vorzugsweise Siliziumdioxid (SiO₂) oder Siliziumoxinitrid (SiON), aufweisen oder daraus sein.

Gemäß einer weiteren Ausführungsform werden im Bereich der zumindest einen ersten Maskenöffnung der ersten Maskenschicht zumindest eine zweite Maskenöffnung in der zweiten Maskenschicht und zumindest eine Ausnehmung im Halbleiterkörper ausgebildet. Das bedeutet mit anderen Worten, dass überall dort, wo die erste Maskenschicht eine erste Maskenöffnung aufweist, in der zweiten Maskenschicht eine zweite Maskenöffnung und im Halbleiterkörper eine Ausnehmung ausgebildet werden. Die erste Maskenschicht wird somit unter anderem dazu verwendet, die zweite Maskenschicht zu strukturieren, wobei diese Strukturierung nicht in einem gesonderten Verfahren sondern im Rahmen der Herstellung der zumindest einen Ausnehmung im Halbleiterkörper erfolgt.

Die herzustellende zumindest eine Ausnehmung ragt von der Hauptoberfläche, auf der die erste Maskenschicht aufgebracht wird, bevorzugt in einer Richtung parallel zur Aufwachsrichtung des Halbleiterkörpers in diesen hinein. Insbesondere kann die zumindest eine Ausnehmung im Halbleiterkörper eine sacklochartige Ausnehmung bilden, also eine Ausnehmung, die in den Halbleiterkörper hineinragt, aber nicht durch diesen hindurch reicht. Die Ausnehmung kann somit eine Seitenfläche und eine Bodenfläche aufweisen, die durch Oberflächen des Halbleiterkörpers gebildet werden. Die Seitenfläche umgibt dabei die Bodenfläche und kann durch verschiedene Kristallflächen des Halbleiterkörpers gebildet werden. Insbesondere werden die zumindest eine zweite Maskenöffnung und die zumindest eine Ausnehmung im Halbleiterkörper derart ausgebildet, dass die Ausnehmung mit der zweiten Maskenöffnung von der ersten Maskenöffnung aus gesehen eine Hinterschneidung bildet. Mit anderen Worten bildet die zweite Maskenschicht im Bereich der zweiten Maskenöffnung einen Überhang, der über die Seitenfläche der Ausnehmung ragt. Bei einem Blick in die Ausnehmung von der ersten Maskenschicht her erscheint somit zumindest ein Teil der Seitenfläche der Ausnehmung durch die zweite Maskenschicht abgeschattet.

Gemäß einer weiteren Ausführungsform werden die zumindest eine zweite Maskenöffnung und die zumindest eine Ausnehmung mittels eines gemeinsamen strukturierenden Verfahrens, insbesondere mittels eines gemeinsamen Ätzverfahrens, hergestellt. Das gemeinsame Ätzverfahren, mit dem die Ausbildung der zumindest einen zweiten Maskenöffnung und der zumindest einen Ausnehmung erfolgt, kann insbesondere ein nasschemisches Ätzverfahren sein. Alternativ hierzu kann es auch möglich sein, dass zur Ausbildung der zumindest einen zweiten Maskenöffnung ein erstes Ätzverfahren und zur Ausbildung der zumindest einen Ausnehmung zumindest ein zweites Ätzverfahren verwendet wird. Die Ausbildung der zumindest einen zweiten Maskenöffnung und die Ausbildung der zumindest einen Ausnehmung kann somit mit einem zweistufigen Ätzverfahren, also mit nacheinander durchgeführten ersten und zweiten Ätzverfahren, erfolgen. Das erste Ätzverfahren kann ein trockenchemisches Ätzverfahren sein. Beispielsweise kann es sich bei dem trockenchemischen Ätzverfahren zur Ausbildung der zumindest einen zweiten Maskenöffnung um ein Ätzverfahren handeln, bei dem ein fluorhaltiges Gas, insbesondere ein Fluor-Plasma, verwendet wird. Das zweite Ätzverfahren kann ein nasschemisches Ätzverfahren sein. Das erste und das zweite Ätzverfahren können insbesondere an das Material der zweiten Maskenschicht beziehungsweise das Material des Halbleiterkörpers angepasst sein, insbesondere auch im Hinblick auf die Herstellung einer Hinterschneidung. Hierbei kann es auch möglich sein, dass mit dem ersten Ätzverfahrens bereits ein Teil des Halbleitermaterials des Halbleiterkörpers abgetragen wird und mit dem zweiten Ätzverfahren die endgültige Form der Ausnehmung im Halbleiterkörper, insbesondere die Hinterschneidung, hergestellt wird.

Gemäß einer weiteren Ausführungsform wird eine Kontaktschicht auf die erste Maskenschicht und die Bodenfläche der zumindest einen Ausnehmung aufgebracht. Das Aufbringen der Kontaktschicht kann insbesondere mittels eines gerichteten Abscheideverfahrens, beispielsweise Aufdampfen, erfolgen. Dadurch ist es möglich, dass die Seitenfläche der zumindest einen Ausnehmung aufgrund der Abschattung durch die Hinterschneidung frei oder zumindest im Wesentlichen frei von der Kontaktschicht bleibt. Das bedeutet, dass die Seitenfläche allenfalls bei einem Übergang zwischen der Bodenfläche und der Seitenfläche Kontakt zur Kontaktschicht hat, ohne dass Halbleiterschichten des Halbleiterkörpers, die die Seitenfläche der zumindest einen Ausnehmung bilden, durch die Kontaktschicht kurz geschlossen werden. Somit sind für das Aufbringen der Kontaktschicht insbesondere Verfahren geeignet, die zu keiner konformen Beschichtung führen. Die Kontaktschicht kann insbesondere die dem Halbleiterkörper abgewandte Seite der ersten Maskenschicht und zumindest einen Teil der Bodenfläche der zumindest einen Ausnehmung bedecken. Mit anderen Worten kann die Kontaktschicht die Bodenfläche der zumindest einen Ausnehmung zumindest teilweise oder auch komplett bedecken.

Die Kontaktschicht kann beispielsweise ein Metall wie etwa Titan, Platin, Nickel, Gold, Silber, Aluminium, Rhodium oder eine Mischung daraus aufweisen oder daraus bestehen. Alternativ oder zusätzlich kann die Kontaktschicht ein transparentes leitendes Oxid enthalten oder daraus bestehen. Die Kontaktschicht kann auch eine Mehrzahl von Schichten aufweisen, beispielsweise eine Schicht aus einem Metall oder einer Metalllegierungen, etwa mit oder aus Silber, und eine weitere Schicht aus einem transparenten leitenden Oxid, etwa mit oder aus ZnO.

Gemäß einer weiteren Ausführungsform wird eine Passivierungsschicht auf der Seitenfläche der zumindest einen Ausnehmung aufgebracht. Insbesondere kann die Passivierungsschicht auf der zweiten Maskenschicht, auf der Seitenfläche und der Bodenfläche der zumindest einen Ausnehmung und auf der Kontaktschicht aufgebracht werden. Das bedeutet insbesondere, dass die Passivierungsschicht unstrukturiert und großflächig auf der zweiten Maskenschicht, auf der Seitenfläche und der Bodenfläche der zumindest einen Ausnehmung und auf der Kontaktschicht aufgebracht wird.

Gemäß einer weiteren Ausführungsform wird die erste Maskenschicht vor dem Aufbringen der Passivierungsschicht und nach dem Ausbilden der zumindest einen zweiten Maskenöffnung und der zumindest einen Ausnehmung im Halbleiterkörper sowie nach dem Aufbringen der Kontaktschicht entfernt. Die erste Maskenschicht kann somit insbesondere vor dem Aufbringen der Passivierungsschicht zusammen mit der auf der ersten Maskenschicht aufgebrachten Kontaktschicht entfernt werden, etwa durch ein geeignetes Lift-Off-Verfahren. Dadurch kann erreicht werden, dass die Kontaktschicht lediglich in der zumindest einen Ausnehmung auf der Bodenfläche verbleibt. Die bevorzugt als Hartmaske ausgebildete zweite Maskenschicht kann das Abheben der Kontaktschicht mit der ersten Maskenschicht erleichtern.

Die Passivierungsschicht kann beispielsweise unmittelbar auf der zweiten Maskenschicht aufgebracht werden. Nach dem Aufbringen der Passivierungsschicht bedeckt diese vorzugsweise alle vor dem Aufbringen der Passivierungsschicht freiliegenden Oberflächen der zweiten Maskenschicht, des Halbleiterkörpers im Bereich der zweiten Maskenöffnung und der Ausnehmung im Halbleiterkörper sowie der Kontaktschicht auf der Bodenfläche der zumindest einen Ausnehmung. Insbesondere bedeckt die Passivierungsschicht auch den Bereich der Ausnehmung im Halbleiterkörper, der bei einer Aufsicht auf die zweite Maskenschicht in die Ausnehmung hinein durch die zweite Maskenschicht abgeschattet wird. Die Passivierungsschicht bildet somit bevorzugt eine zusammenhängende Schicht, die sich von der dem Halbleiterkörper abgewandten Oberfläche der zweiten Maskenschicht durch die zumindest eine zweite Maskenöffnung hindurch über die Hinterschneidung und über die Oberflächen der zumindest einen Ausnehmung mit der Kontaktschicht erstreckt. Dies kann durch ein ungerichtetes Abscheideverfahren, beispielsweise ein chemisches Dampfphasenabscheideverfahren wie etwa Plasma-unterstützte chemische Gasphasenabscheidung (PECVD: "plasma-enhanced chemical vapor deposition") oder Atomlagenabscheidung (ALD: "atomic layer deposition") erfolgen. Insbesondere ist beim Ausbilden der Passivierungsschicht ein Verfahren von Vorteil, dass eine konforme Beschichtung der zu beschichtenden Oberflächen ermöglicht, so dass auch abgeschattete Bereiche mit der Passivierungsschicht beschichtet werden können. Die Passivierungsschicht kann insbesondere ein elektrisch isolierendes Material aufweisen. Die Passivierungsschicht kann beispielsweise ein Oxid oder Oxinitrid aufweisen, etwa Siliziumdioxid (SiO₂) oder Siliziumoxinitrid (SiON). Insbesondere kann es auch möglich sein, dass die zweite Maskenschicht und die Passivierungsschicht ein gleiches Material aufweisen.

Gemäß einer weiteren Ausführungsform wird die Passivierungsschicht von der Bodenfläche der zumindest einen Ausnehmung entfernt. Weiterhin kann die Passivierungsschicht von der auf der Bodenfläche aufgebrachten Kontaktschicht entfernt werden. Das kann insbesondere bedeuten, dass zumindest ein Teil der Bodenfläche der zumindest einen Ausnehmung und zumindest ein Teil der Kontaktschicht durch Entfernen der Passivierungsschicht freigelegt wird. Weiterhin kann die Passivierungsschicht auch von der dem Halbleiterkörper abgewandten Seite der zweiten Maskenschicht entfernt werden. Insbesondere wird die Passivierungsschicht so von der Bodenfläche der zumindest einen Ausnehmung und der Kontaktschicht entfernt, dass die Passivierungsschicht auf der Seitenfläche der zumindest einen Ausnehmung zumindest teilweise verbleibt. Mit anderen Worten wird somit die Bodenfläche der zumindest einen Ausnehmung mit der Kontaktschicht freigelegt, während die Seitenfläche durch zumindest einen Teil der Passivierungsschicht bedeckt bleibt. Besonders bevorzugt verbleibt die Passivierungsschicht nur auf der Seitenfläche der zumindest einen Ausnehmung im Halbleiterkörper. Die Passivierungsschicht kann von der Bodenfläche und der Kontaktschicht beispielsweise derart entfernt werden, dass die Passivierungsschicht im Bereich der Bodenfläche der zumindest einen Ausnehmung an die Kontaktschicht anschließt.

Das Entfernen der Passivierungsschicht kann beispielsweise mittels eines gerichteten Rückätzverfahrens erfolgen, so dass die Passivierungsschicht gezielt von der Bodenfläche der zumindest einen Ausnehmung, von der Kontaktschicht und gegebenenfalls von der dem Halbleiterkörper abgewandten Seite der zweiten Maskenschicht entfernt werden kann. Das gerichtete Rückätzverfahren kann beispielsweise ein trockenchemisches Ätzverfahren sein, beispielsweise unter Verwendung eines Fluor-haltigen Gases, etwa einem Fluor-Plasma. Dadurch, dass die zweite Maskenschicht mit der zumindest einen Ausnehmung im Halbleiterkörper eine Hinterschneidung bildet und somit die Seitenfläche der zumindest einen Ausnehmung durch die zweite Maskenschicht abgeschattet ist, kann erreicht werden, dass für das gerichtete Rückätzverfahren durch die zumindest eine zweite Maskenöffnung hindurch nur die Bodenfläche und somit auch die Kontaktschicht auf dieser, nicht aber die Seitenfläche der Ausnehmung zugänglich ist. Zum Entfernen der Passivierungsschicht kann somit ein großflächiges gerichtetes Rückätzverfahren verwendet werden, ohne dass eine gesonderte Maske erforderlich ist. Vielmehr bildet die zweite Maskenschicht die für das Entfernen der Passivierungsschicht erforderliche Maske.

Bei dem hier beschriebenen Verfahren handelt es sich somit um eine selbstjustierende Prozessfolge durch das Zusammenlegen der Definition der zumindest einen Ausnehmung im Halbleiterkörper und der Herstellung der zweiten Maskenöffnung in der zweiten Maskenschicht. Durch die zweite Maskenschicht ist eine Strukturierung der Kontaktschicht wie auch der Passivierungsschicht unter Verwendung derselben Maske möglich, wobei die geometrischen Abmessungen beispielsweise der Kontaktschicht durch die erste Maskenöffnung der ersten Masken bestimmt werden können, insbesondere wenn, wie weiter unten beschrieben ist, die zweite Maskenschicht nasschemisch strukturiert wird. Dadurch sind im Vergleich zu bekannten Verfahren eine vereinfachte Prozessführung und damit eine Kostenreduktion sowie ein verringerter Platzbedarf möglich. Auch sind keine Anforderungen an die Neigung der Seitenfläche der zumindest einen Ausnehmung im Halbleiterkörper gestellt, so lange sichergestellt ist, dass die zweite Maskenschicht einen ausreichend großen Überhang über der Seitenfläche der zumindest einen Ausnehmung bildet, um diese für die Verfahren zum Aufbringen der Kontaktschicht und zum Entfernen der Passivierungsschicht ausreichend abzuschatten.

Gemäß einer weiteren Ausführungsform verbleibt die zweite Maskenschicht nach dem selektiven Entfernen der Passivierungsschicht auf dem Halbleiterkörper. Zusammen mit der Passivierungsschicht auf der Seitenfläche der zumindest einen Ausnehmung des Halbleiterkörpers kann eine zusammenhängende Isolationsschicht auf dem Halbleiterkörper gebildet werden. Diese Isolationsschicht kann so ausgestaltet sein, dass sie im Wesentlichen nur die Bodenfläche der zumindest einen Ausnehmung mit der Kontaktschicht nicht bedeckt.

Gemäß einer weiteren Ausführungsform wird zwischen der ersten und zweiten Maskenschicht eine Ätzstoppschicht aufgebracht. Die Ätzstoppschicht kann somit als Deckschicht auf der zweiten Maskenschicht vor der Ausbildung der ersten Maskenschicht mit der zumindest einen ersten Maskenöffnung aufgebracht werden.

Gemäß einer weiteren Ausführungsform wird im Rahmen der oben beschriebenen Ausbildung der zumindest einen zweiten Maskenöffnung in der zweiten Maskenschicht im Bereich der zumindest einen ersten Maskenöffnung der ersten Maskenschicht zusätzlich eine Öffnung in der Ätzstoppschicht ausgebildet. Je nach Material der Ätzstoppschicht kann das Ausbilden der Öffnung in der Ätzstoppschicht gleichzeitig, also mit einem selben Verfahren, mit der Ausbildung der zumindest einen zweiten Maskenöffnung in der zweiten Maskenschicht erfolgen. Alternativ hierzu kann ein eigenes Verfahren, insbesondere ein Ätzverfahren, zur Herstellung der zumindest einen Öffnung in der Ätzstoppschicht verwendet werden. Beispielsweise kann die Ätzstoppschicht Aluminiumoxid (Al₂O₃) aufweisen oder daraus sein. Zum selektiven Öffnen der Ätzstoppschicht kann sich in diesem Fall insbesondere Phosphorsäure (H₃PO₄) eignen. Nach der Ausbildung der zumindest einen zweiten Maskenöffnung und der zumindest einen Ausnehmung im Halbleiterkörper verbleibt die Ätzstoppschicht somit vorzugsweise nur auf der vom Halbleiterkörper abgewandten Seite der zweiten Maskenschicht.

Alternativ zum Aufbringen einer Ätzstoppschicht vor dem Ausbilden der zumindest einen zweiten Maskenöffnung in der zweiten Maskenschicht kann die Ätzstoppschicht auch nach dem Ausbilden der zumindest einen zweiten Maskenöffnung und der zumindest einen Ausnehmung und nach dem Aufbringen der Kontaktschicht großflächig aufgebracht werden. Insbesondere kann die Ätzstoppschicht nach dem Entfernen der ersten Maskenschicht aufgebracht werden. Mit anderen Worten kann die Ätzstoppschicht vor dem Aufbringen der Passivierungsschicht in einer Weise erfolgen, wie weiter oben für die Passivierungsschicht beschrieben ist. Das kann insbesondere bedeuten, dass die Ätzstoppschicht in diesem Fall nach dem Aufbringen die Seitenfläche und die Bodenfläche der zumindest einen Ausnehmung im Halbleiterkörper und die Kontaktschicht in der Ausnehmung bedeckt.

Unabhängig vom Zeitpunkt, zu dem die Ätzstoppschicht aufgebracht wird, kann die Passivierungsschicht auf der Ätzstoppschicht aufgebracht werden, so dass die Ätzstoppschicht nach dem Aufbringen der Passivierungsschicht von dieser vollständig bedeckt ist. Das bedeutet mit anderen Worten, dass für den Fall eines großflächigen Aufbringens der Ätzstoppschicht anschließend die Passivierungsschicht ebenfalls großflächig auf dieser aufgebracht wird.

Das Entfernen der Passivierungsschicht insbesondere zumindest von der Bodenfläche der zumindest einen Ausnehmung kann auch bei Anwesenheit einer Ätzstoppschicht in der weiter oben beschriebenen Weise erfolgen. Bedeckt die Ätzstoppschicht unter anderem auch die Bodenfläche der zumindest einen Ausnehmung und die Kontaktschicht in der zumindest einen Ausnehmung, kann die Ätzstoppschicht nach dem selektiven Entfernen der Passivierungsschicht im Bereich der Bodenfläche der Ausnehmung im Halbleiterkörper in ähnlicher Weise wie die Passivierungsschicht durch ein gerichtetes Ätzverfahren selektiv entfernt werden. Weiterhin kann es auch möglich sein, die Ätzstoppschicht nasschemisch selektiv zu entfernen.

Je nach Verwendung der Ätzstoppschicht können die zweite Maskenschicht oder die zweite Maskenschicht, die Bodenfläche der Ausnehmung im Halbleiterkörper und die Kontaktschicht in der Ausnehmung während des selektiven Entfernens der Passivierungsschicht insbesondere bei der Verwendung des vorab beschriebenen gerichteten Rückätzverfahrens geschützt werden. Beispielsweise kann Aluminiumoxid als Material für die Ätzstoppschicht sehr selektiv gegen Fluor-haltige Gase wirken, so dass beim Entfernen der Passivierungsschicht mittels solcher Materialien die unter der Ätzstoppschicht liegenden Materialien geschützt werden. Durch den Einsatz der Ätzstoppschicht kann die weitere Prozessführung mit geringeren Anforderungen insbesondere in Bezug auf die Dauer des Verfahrens zur Entfernung der Passivierungsschicht durchgeführt werden. So kann länger überätzt werden, ohne in das Problem zu laufen, dass die zweite Maskenschicht geschädigt beziehungsweise durchgeätzt wird. Wird die Ätzstoppschicht unmittelbar vor der Passivierungsschicht abgeschieden, so verbleibt die Ätzstoppschicht zusammen mit der Passivierungsschicht zumindest teilweise auf der Seitenfläche der zumindest einen Ausnehmung, nachdem die Ätzstoppschicht und die Passivierungsschicht von der dem Halbleiterkörper abgewandten Seite der zweiten Maskenschicht, von der Bodenfläche der zumindest einen Ausnehmung und von der Kontaktschicht entfernt worden sind. Die Ätzstoppschicht bildet in diesem Fall einen funktionalen Teil der Passivierung der Seitenfläche der zumindest einen Ausnehmung im Halbleiterkörper.

Gemäß einer weiteren Ausführungsform wird bei einem Verfahren zur Herstellung eines Halbleiterchips mit zumindest einer Durchkontaktierung ein Halbleiterkörper mit zumindest einer mit einer Kontaktschicht versehenen Ausnehmung gemäß einer oder mehrerer der vorherigen Ausführungsformen hergestellt. Zur Fertigstellung der Durchkontaktierung kann die mit der Kontaktschicht versehene Ausnehmung mit einem elektrisch leitenden Material, insbesondere einem Metall oder einer Legierung, gefüllt werden. Da die zumindest eine Ausnehmung im Halbleiterkörper bevorzugt ausschließlich im Bereich der Bodenfläche der Ausnehmung die Kontaktschicht aufweist, steht das elektrisch leitende Material, mit dem die Ausnehmung verfüllt ist, an der Bodenfläche über die Kontaktschicht mit der entsprechenden, die Bodenfläche bildenden Halbleiterschicht des Halbleiterkörpers in guter elektrischer Verbindung. Der Halbleiterkörper kann mit der durch die zweite Maskenschicht gebildeten Seite auf einem Träger montiert werden, beispielsweise unter Verwendung einer Verbindungsschicht. Die durch die zumindest eine Durchkontaktierung kontaktierte Halbleiterschicht kann somit von der dem Träger zugewandten Seite des Halbleiterkörpers her kontaktiert werden.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
- Figur 1: eine schematische Darstellung eines Beispiels für einen Halbleiterchip mit Durchkontaktierungen,
- Figuren 2A bis 2E: schematische Darstellungen von Verfahrensschritten eines Verfahrens gemäß einem Ausführungsbeispiel,
- Figuren 3A und 3B: schematische Darstellungen von Verfahrensschritten eines Verfahrens gemäß einem weiteren Ausführungsbeispiel und
- Figuren 4A bis 4C: schematische Darstellungen von Verfahrensschritten eines Verfahrens gemäß einem weiteren Ausführungsbeispiel.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

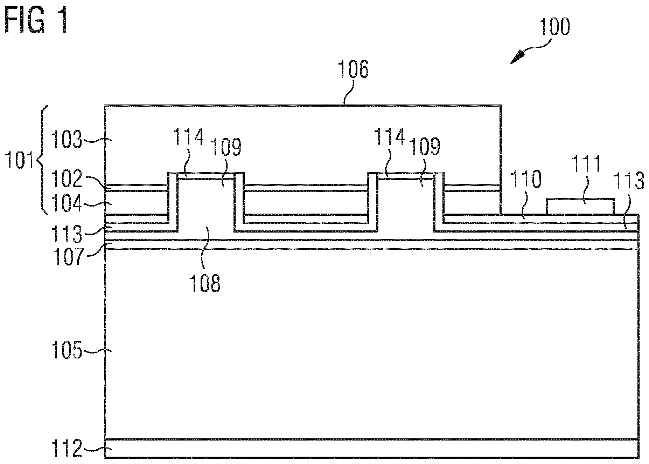

Zum besseren Verständnis der in den nachfolgenden Ausführungsbeispielen beschriebenen Verfahren ist in Figur 1 ein Halbleiterchip 100 gezeigt, der in einem Halbleiterkörper 101 Durchkontaktierungen in Form sogenannter Vias aufweist.

Der Halbleiterchip 100 weist eine Halbleiterschichtenfolge auf, die den Halbleiterkörper 101 bildet und die einen zur Lichterzeugung vorgesehenen aktiven Bereich 102 aufweist, der zwischen einer ersten Halbleiterschicht 103 und einer zweiten Halbleiterschicht 104 angeordnet ist. Der Halbleiterkörper 101 ist im gezeigten Beispiel auf einem Träger 105 aufgebracht. Die erste Halbleiterschicht 103 ist auf der vom Träger 105 abgewandten Seite des aktiven Bereichs 102 angeordnet. Als Material für den Träger 105 eignet sich beispielsweise ein Halbleitermaterial wie etwa Germanium oder Silizium, das dotiert sein kann.

Die erste Halbleiterschicht 103 und die zweite Halbleiterschicht 104 weisen voneinander verschiedene Leitungstypen auf, so dass der aktive Bereich 102 in einer Diodenstruktur angeordnet ist. Beispielsweise können die erste Halbleiterschicht 103 n-leitend und die zweite Halbleiterschicht 104 p-leitend ausgeführt sein oder umgekehrt.

Die dem Träger 105 abgewandte Seite des Halbleiterkörpers 101 bildet eine Strahlungsaustrittsfläche 106 des Halbleiterchips 100. Im Betrieb des Halbleiterchips 100 wird im aktiven Bereich 102 Licht erzeugt, das vorzugsweise überwiegend durch die Strahlungsaustrittsfläche 106 aus dem Halbleiterchip 100 austritt.

Der Halbleiterkörper 101, insbesondere der aktive Bereich 102, enthält vorzugsweise ein III-V-Halbleitermaterial. III-V-Halbleitermaterialien sind zur Strahlungserzeugung im ultravioletten (InₓGa_{y}Al_{1-x-y}N) über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet. Hierbei gilt jeweils 0 ≤ x ≤ 1, 0 ≤ y ≤ 1 und x + y ≤ 1 insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Der Halbleiterkörper 101 ist mittels einer Verbindungsschicht 107 stoffschlüssig mit einer dem Halbleiterkörper 101 zugewandten Hauptoberfläche des Trägers 105 verbunden. Die Verbindungsschicht 107 kann beispielsweise eine Klebstoffschicht, insbesondere eine elektrisch leitende Klebstoffschicht, oder eine Lotschicht sein.

Zwischen dem Halbleiterkörper 101 und dem Träger 105 ist weiterhin eine erste Anschlussschicht 108 ausgebildet. Der Halbleiterkörper 101 weist eine Mehrzahl von Ausnehmungen 109 auf, die sich durch die zweite Halbleiterschicht 104 und durch den aktiven Bereich 102 hindurch in die erste Halbleiterschicht 103 hinein erstrecken. Die erste Anschlussschicht 108 verläuft durch die Ausnehmungen 109 hindurch und stellt von der dem Träger 105 zugewandten Seite des Halbleiterkörpers 101 her eine elektrisch leitende Verbindung zur ersten Halbleiterschicht 103 her, so dass die erste Halbleiterschicht 103 durch die dadurch gebildeten Durchkontaktierungen von der Trägerseite her elektrisch kontaktiert werden kann. Zwischen der ersten Anschlussschicht 108 und der ersten Halbleiterschicht 103 ist in den Ausnehmungen 109 in Kontakt mit der ersten Halbleiterschicht 103 jeweils noch eine Kontaktschicht 114 angeordnet, die zur Verbesserung eines elektrischen Kontakts zwischen der ersten Anschlussschicht 108 und der ersten Halbleiterschicht 103 dient. Weiterhin ist zwischen dem Halbleiterkörper 101 und dem Träger 105 eine zweite Anschlussschicht 110 ausgebildet, die der elektrischen Kontaktierung der zweiten Halbleiterschicht 104 dient.

Die Mehrzahl von Ausnehmungen 109 und damit die Mehrzahl von Durchkontaktierungen dient einer in lateraler Richtung gleichmäßigen Injektion von Ladungsträgern über die erste Halbleiterschicht 103 in den aktiven Bereich 102. Die Ausnehmungen 109 können beispielsweise matrixartig oder in Form eines Wabenmusters angeordnet sein. Insbesondere bei hinreichender Querleitfähigkeit der ersten Halbleiterschicht 103 ist auch eine Ausführung des Halbleiterchips 100 denkbar, die lediglich eine einzige Ausnehmung 109 und damit eine einzige Durchkontaktierung zur elektrischen Kontaktierung der ersten Halbleiterschicht 103 aufweist.

Die erste Anschlussschicht 108 und/oder die zweite Anschlussschicht 110 und/oder die Kontaktschichten 114 enthalten vorzugsweise jeweils ein Metall, beispielsweise Titan, Platin, Nickel, Gold, Silber, Aluminium oder Rhodium oder eine metallische Legierung mit zumindest einem der genannten Materialien oder bestehen aus einem Metall oder einer metallischen Legierung. Alternativ oder ergänzend können die erste Anschlussschicht 108 und/oder die zweite Anschlussschicht 110 und/oder die Kontaktschichten 114 ein transparentes leitendes Oxid enthalten oder aus einem solchen Material bestehen. Transparente leitende Oxide ("transparent conductive oxide", TCO) sind transparente, leitende Materialien, in der Regel Metalloxide, wie beispielsweise Zinkoxid, Zinnoxid, Aluminiumzinnoxid, Cadmiumoxid, Titanoxid, Indiumoxid und Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Die zweite Anschlussschicht 110 weist weiterhin bevorzugt für das im aktiven Bereich 102 erzeugte Licht eine hohe Reflektivität auf. Im ultravioletten und blauen Spektralbereich eignet sich im Hinblick auf eine hohe Reflektivität beispielsweise Silber, Aluminium oder Rhodium, im roten und infraroten Spektralbereich beispielsweise Gold. Mittels einer reflektierend ausgebildeten zweiten Anschlussschicht 110 kann im aktiven Bereich 102 erzeugtes und in Richtung des Trägers 105 abgestrahltes Licht in Richtung der Strahlungsaustrittsfläche 106 umgelenkt werden und durch diese aus dem Halbleiterchip 100 austreten.

Der Halbleiterchip 100 weist Kontakte 111, 112 auf, die zur externen elektrischen Kontaktierung des Halbleiterchips 100 vorgesehen sind. Im Betrieb des Halbleiterchips 100 können durch Anlegen einer elektrischen Spannung zwischen den Kontakten 111, 112 Ladungsträger von verschiedenen Seiten in den aktiven Bereich 102 injiziert werden und dort unter Lichtemission rekombinieren.

Die Kontakte 111, 112 können insbesondere ein im Zusammenhang mit der ersten und zweiten Anschlussschicht 108, 110 genanntes Metall oder eine metallische Legierung mit einem dieser Materialien enthalten oder aus einem solchen Material bestehen. Insbesondere eigenen sich Materialien, mit denen auf einfache Weise eine externe elektrische Kontaktierung, etwa mittels eines Bonddrahts oder mittels einer Lötverbindung herstellbar ist. Beispielsweise ist Gold als Material für die Kontakte 111, 112 besonders geeignet.

Zur Vermeidung eines elektrischen Kurzschlusses des aktiven Bereichs 102 ist zwischen den Seitenflächen der Ausnehmungen 109 und der ersten Anschlussschicht 108 eine Isolationsschicht 113 ausgebildet. Weiterhin verläuft die Isolationsschicht 113 zwischen den Anschlussschichten 108 und 110, so dass ein elektrischer Kurzschluss zwischen diesen auf einfache Weise vermieden werden kann. Die Isolationsschicht 113 kann beispielsweise ein Oxid, etwa Siliziumoxid oder Titanoxid, ein Nitrid, etwa Siliziumnitrid oder ein Oxinitrid, etwa Siliziumoxinitrid enthalten oder aus einem solchen Material bestehen.

Die elektrische Kontaktierung der Anschlussschichten 108, 110 mittels der Kontakte 111, 112 erfolgt im gezeigten Beispiel lediglich exemplarisch mittels einer Anordnung der Kontakte 111, 112 auf gegenüberliegenden Seiten des Trägers 105 und einer Injektion von Ladungsträgern durch einen elektrisch leitfähigen, unstrukturierten Träger 105. Von dem gezeigten Beispiel abweichend kann der Träger 105 auch zumindest eine Aussparung aufweisen, die sich in vertikaler Richtung durch den Träger 105 hindurch erstreckt und die mit einem elektrisch leitfähigen Material, etwa einem Metall, befüllt ist. In diesem Fall kann der Träger 105 auch elektrisch isolierend ausgebildet sein. Beispielsweise kann der Träger 105 in diesem Fall eine Keramik, etwa Aluminiumnitrid, Aluminiumoxid oder Siliziumnitrid enthalten oder aus einem solchen Material bestehen.

Weiterhin kann die vom Halbleiterkörper 101 abgewandte Seite des Trägers 105 vom gezeigten Beispiel abweichend frei von einem elektrischen Kontakt ausgebildet sein. Die elektrischen Kontakte 111, 112 können also beide auf der dem Halbleiterkörper 101 zugewandten Seite des Trägers 105 angeordnet sein. In diesem Fall ist der Träger 105 vorzugsweise elektrisch isolierend ausgebildet. Davon abweichend kann aber auch ein elektrisch leitfähiger Träger 105 Verwendung finden.

Als weitere Alternative können von dem gezeigten Beispiel abweichend die Kontakte 111, 112 auf der dem Halbleiterkörper 101 abgewandten Seite des Trägers 105 angeordnet sein, so dass der Halbleiterchip 100 ausschließlich von einer Seite des Trägers 105 her elektrisch kontaktierbar ist. Beispielsweise kann in dem Träger 105 für die elektrische Kontaktierung der ersten Anschlussschicht 108 und für die elektrische Kontaktierung der zweiten Anschlussschicht 110 jeweils zumindest eine Aussparung im, vorzugsweise elektrisch isolierend ausgebildeten, Träger 105 vorgesehen sein, die sich jeweils in vertikaler Richtung durch den Träger 105 hindurch erstrecken.

Der in Figur 1 gezeigt Halbleiterchip 100, der als Leuchtdiodenchip oder als Laserdiodenchip ausgebildet sein kann, ist nur rein beispielhaft und nicht als Einschränkung für die nachfolgenden Ausführungsbeispiele zu verstehen. Insbesondere kann der Halbleiterchip 100 auch anstelle eines Licht emittierenden aktiven Bereichs 102 einen Licht absorbierenden aktiven Bereich aufweisen. Weiterhin kann der Halbleiterchip 100 auch zusätzlich oder alternativ eine nicht-optoelektronische Funktionalität aufweisen, beispielsweise in Form einer nicht-Licht-emittierenden Diode oder eines Transistors.

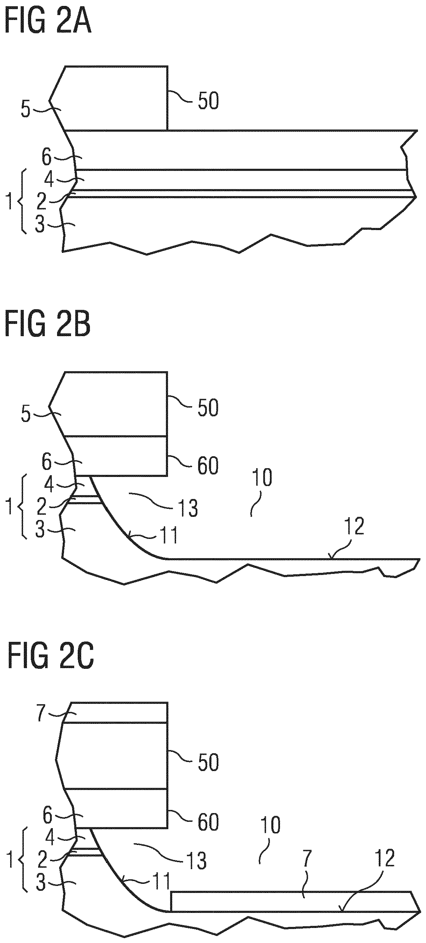

In Verbindung mit den nachfolgenden Figuren 2A bis 4C sind Ausführungsbeispiele für Verfahren zur Herstellung von zumindest einer mit einer Kontaktschicht 7 versehenen Ausnehmung 10 in einem Halbleiterkörper 1 gezeigt. Die zumindest eine mit einer Kontaktschicht 7 versehene Ausnehmung 10 kann weiterhin im Rahmen eines Verfahrens zur Herstellung eines Halbleiterchips mit einem elektrisch leitenden Material zur Bildung einer oben beschriebenen Anschlussschicht verfüllt werden, so dass das in der Ausnehmung angeordnete elektrisch leitende Material eine Durchkontaktierung bildet.

Rein beispielhaft und ohne Beschränkung der Allgemeinheit können die nachfolgend gezeigten Halbleiterkörper 1 wie der Halbleiterkörper 101 des Halbleiterchips 100 der Figur 1 ausgebildet sein und auch ohne weitere explizite Verweise Merkmale gemäß dem Beispiel der Figur 1 aufweisen. Die nachfolgend beschriebenen Verfahren sind jedoch auch auf andere Halbleiterkörper anwendbar, die beispielsweise andere Schichtenfolgen und/oder Materialien als der Halbleiterkörper 101 gemäß der vorangegangenen Beschreibung aufweisen können.

In Verbindung mit der Figuren 2A bis 2E ist ein Ausführungsbeispiel für ein Verfahren zur Herstellung eines Halbleiterkörpers mit zumindest einer mit einer Kontaktschicht versehenen Ausnehmung gezeigt. In den Figuren 2A bis 2E sowie auch in den nachfolgenden Figuren ist jeweils ein Ausschnitt des Halbleiterkörpers 1 sowie auch der darauf aufgebrachten Schichten, der Öffnungen und der Ausnehmung im Halbleiterkörper 1 dargestellt.

Wie in Figur 2A gezeigt ist, wird ein Halbleiterkörper 1, im gezeigten Ausführungsbeispiel in Form einer Halbleiterschichtenfolge mit einem aktiven Bereich 2 zwischen einer ersten Halbleiterschicht 3 und einer zweiten Halbleiterschicht 4, bereitgestellt. Die Halbleiterschichtenfolge kann beispielsweise epitaktisch, etwa mittels metallorganischer Gasphasenabscheidung (MOVPE: "metal-organic gas vapor deposition") oder Molekülstrahlepitaxie (MBE: "molecular beam epitaxy") auf einem Aufwachssubstrat abgeschieden werden. Davon abweichend kann der Halbleiterkörper 1 auch auf einem vom Aufwachssubstrat verschiedenen Hilfsträger bereitgestellt werden.

Im Rahmen von nachfolgend beschriebenen Verfahrensschritten wird von der dem Aufwachssubstrat oder gegebenenfalls dem Hilfsträger abgewandten Seite des Halbleiterkörpers her zumindest eine Ausnehmung 10 ausgebildet, die sich in den Halbleiterkörper 1 hinein erstreckt, wie beispielsweise in Figur 2B gezeigt ist. Dies erfolgt zweckmäßigerweise nach dem Abschluss der Abscheidung der Halbleiterschichtenfolge und somit nach Abschluss der Herstellung des Halbleiterkörpers 1, so dass der Halbleiterkörper 1 entlang einer Richtung entlang der Aufwachsrichtung der Halbleiterschichtenfolge mit einer Hauptoberfläche, die senkrecht zur Aufwachsrichtung sein kann, abschließt. Im gezeigten Ausführungsbeispiel erstreckt sich die zumindest eine Ausnehmung 10 von dieser Hauptoberfläche durch die zweite Halbleiterschicht 4 und den aktiven Bereich 2 hindurch in die erste Halbleiterschicht 3 hinein.

Zu Ausbildung der zumindest einen Ausnehmung 10 im Halbleiterkörper 1 werden, wie in Figur 2A gezeigt ist, auf dem Halbleiterkörper 1 eine erste Maskenschicht 5 und eine zweite Maskenschicht aufgebracht, wobei die zweite Maskenschicht 6 zwischen der ersten Maskenschicht 5 und dem Halbleiterkörper 1 angeordnet ist. Das bedeutet mit anderen Worten, dass auf dem Halbleiterkörper 1 zuerst die zweite Maskenschicht 6 aufgebracht wird und anschließend auf der zweiten Maskenschicht 6 die erste Maskenschicht 5 abgeschieden wird. Die Maskenschichten 5, 6 werden insbesondere auf der entlang der Aufwachsrichtung abschließenden Hauptoberfläche des Halbleiterkörpers 1 aufgebracht.

Die erste Maskenschicht 5 wird strukturiert mit zumindest einer ersten Maskenöffnung 50 auf der zweiten Maskenschicht 6 aufgebracht. Hierzu kann beispielsweise ein Fotolack als Material für die erste Maskenschicht 5 aufgebracht werden, der unter Zuhilfenahme geeigneter Belichtungs- und Entwicklungsschritte zur Ausbildung der ersten Maskenöffnung 50 strukturiert wird. Wie oben erwähnt ist die erste Maskenöffnung 50, die den Bereich definiert, in dem die Ausnehmung 10 im Halbleiterkörper 1 hergestellt werden soll, in Figur 2A und in den nachfolgenden Figuren nur ausschnittsweise gezeigt. Die erste Maskenschicht 5 kann insbesondere eine oder mehrere erste Maskenöffnungen 50 aufweisen, je nachdem, wie viele Ausnehmungen 10 im Halbleiterkörper ausgebildet werden sollen.

Vor dem Aufbringen der ersten Maskenschicht 5 wird auf dem Halbleiterkörper 1 die zweite Maskenschicht 6 großflächig und unstrukturiert aufgebracht. Insbesondere kann es sich bei der zweiten Maskenschicht 6 um eine Hartmaske handeln, die beispielsweise ein Oxid oder Oxinitrid wie etwa Siliziumdioxid oder Siliziumoxinitrid aufweist oder daraus besteht. Die Ausbildung der zweiten Maskenschicht 6 kann mit einem geeigneten, großflächig wirkenden Verfahren erfolgen, beispielsweise einem chemischen oder physikalischen Gasphasenabscheideverfahren.

In einem weiteren Verfahrensschritt werden, wie in Figur 2B gezeigt ist, zumindest eine zweite Maskenöffnung 60 in der zweiten Maskenschicht 6 und zumindest eine Ausnehmung 10 im Halbleiterkörper 1 im Bereich der zumindest einen ersten Maskenöffnung 50 der ersten Maskenschicht 5 ausgebildet. Hierzu kann insbesondere ein Ätzverfahren verwendet werden, beispielsweise ein nasschemisches Ätzverfahren. Die Ausbildung der zumindest einen zweiten Maskenöffnung 60 und der zumindest einen Ausnehmung 10 kann insbesondere mittels eines gemeinsamen Ätzverfahrens erfolgen. Die Ätzparameter werden dabei derart eingestellt, dass die Ausnehmung 10, die eine Seitenfläche 11 und eine Bodenfläche 12 aufweist, mit der zweiten Maskenöffnung 60 von der ersten Maskenöffnung 50 aus gesehen eine Hinterschneidung 13 bildet. Dies bedeutet mit anderen Worten, dass die zweite Maskenöffnung 60 einen kleineren Querschnitt aufweist als die Ausnehmung 10 in einem Bereich direkt unterhalb der zweiten Maskenöffnung 60. Dadurch überragt die zweite Maskenschicht 6 die Ausnehmung 10 im Randbereich der Ausnehmung 10, so dass bei einer Aufsicht auf die erste beziehungsweise zweite Maskenschicht 5, 6 und in die Ausnehmung 10 hinein die Seitenfläche 11 der Ausnehmung 10 durch die zweite Maskenschicht 6 abgeschattet ist.

Die erste und zweite Maskenöffnung 50, 60 und entsprechend die Ausnehmung 10 können eine runde oder eine eckige Querschnittsform aufweisen. Die erste und zweite Maskenöffnung 50, 60 können jeweils Abmessungen im Bereich von einigen zehn Mikrometern, beispielsweise etwa 30 µm bis etwa 50 µm, aufweisen. Die Tiefe der Unterätzung des Halbleiterkörpers 1 unmittelbar unter der zweiten Maskenschicht 6, also die Größe der Hinterschneidung 13, ist größer oder gleich der Dicke der später aufgebrachten Passivierungsschicht 8 und kann beispielsweise bis zu 300 nm betragen, während die Tiefe der Ausnehmung 10 in den Halbleiterkörper 1 hinein beispielsweise etwa 600 nm bis 700 nm betragen kann, je nachdem, wie dick der Bereich der Halbleiterschichtenfolge ist, der durch die Durchkontaktierung überbrückt werden soll. Zwischen der zweiten Maskenschicht 6 und dem Halbleiterkörper 1 kann in einem Abstand, beispielsweise einem Abstand von einem oder mehreren Mikrometern, typischerweise etwa 5 µm, eine Kontaktmetallisierung wie die oben in Verbindung mit Figur 1 beschriebene Anschlussschicht 110 angeordnet sein. Die beschriebenen Bemaßungen sind rein beispielhaft zu verstehen und können je nach Ausbildung des Halbleiterkörpers 1 und je nach den Anforderungen an den herzustellenden Halbleiterchip auch von den angegebenen Werten abweichen.

In Figur 2C ist ein weiterer Verfahrensschritt gezeigt, in dem eine Kontaktschicht 7 auf die erste Maskenschicht 5 und die Bodenfläche 12 der zumindest einen Ausnehmung 10 aufgebracht wird. Das Aufbringen der Kontaktschicht 7 erfolgt großflächig und mittels eines gerichteten Abscheideverfahrens. Insbesondere kann die Kontaktschicht 7 aufgedampft werden, insbesondere aus einer Richtung senkrecht zur dem Halbleiterkörper 1 abgewandten Oberseite der ersten Maskenschicht 5. Durch die Hinterschneidung 13 wird die Seitenfläche 11 der Ausnehmung 10 abgeschattet, so dass die Seitenfläche 11 frei oder zumindest im Wesentlichen frei von der Kontaktschicht bleibt. Das bedeutet, dass die Seitenfläche 11 allenfalls im Bereich des Übergangs zwischen der Bodenfläche 12 und der Seitenfläche 11 Kontakt zur Kontaktschicht 7 hat. Jedoch ragt die Kontaktschicht 7 nicht so weit entlang der Seitenfläche 11 nach oben, dass Halbleiterschichten des Halbleiterkörpers 1, die die Seitenfläche 11 bilden, kurzgeschlossen werden. Durch das großflächige gerichtete Aufbringen der Kontaktschicht 7 bedeckt diese die dem Halbleiterkörper 1 abgewandte Seite der ersten Maskenschicht 5 und zumindest einen Teil der Bodenfläche 12 der zumindest einen Ausnehmung 10. Im gezeigten Ausführungsbeispiel bedeckt die Kontaktschicht 7 die Bodenfläche 12 der zumindest einen Ausnehmung 10 nahezu komplett.

Die Kontaktschicht kann eines oder mehrere der oben im Zusammenhang mit der Kontaktschicht 114 des Halbleiterchips 100 der Figur 1 beschriebenen Materialien in einer oder mehreren Schichten aufweisen oder daraus sein. Beispielsweise kann die Kontaktschicht 7 Silber und/oder ZnO aufweisen oder daraus sein.

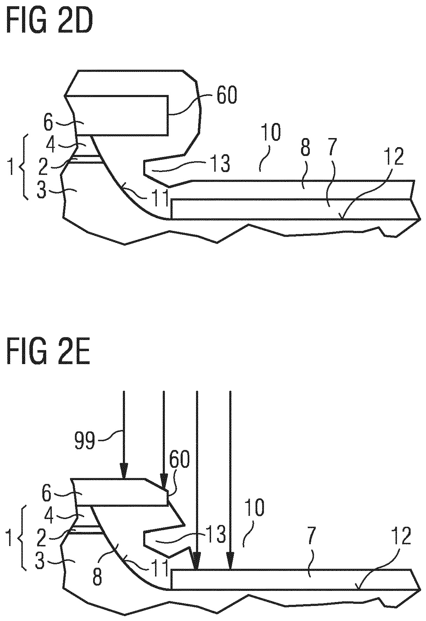

In einem weiteren Verfahrensschritt wird, wie in Figur 2D gezeigt ist, großflächig und unstrukturiert eine Passivierungsschicht 8 aufgebracht. Hierzu wird vor dem Aufbringen der Passivierungsschicht 8 insbesondere die erste Maskenschicht 5 mit der darauf angeordneten Kontaktschicht 7 entfernt, so dass die Kontaktschicht 7 nur noch in der zumindest einen Ausnehmung 10 im Halbleiterkörper 1 angeordnet ist.

Die Passivierungsschicht 8 wird mit einem Verfahren aufgebracht, das geeignet ist, alle freiliegenden Oberflächen der zweiten Maskenschicht 6 und alle freiliegenden Oberflächen der Ausnehmung 10 und der in der Ausnehmung 10 angeordneten Kontaktschicht 7 möglichst gleichmäßig und zumindest mit einer geschlossenen Schicht zu bedecken. Beispielsweise kann ein plasmaunterstütztes chemisches Gasphasenabscheideverfahren oder ein Atomlagenabscheideverfahren verwendet werden. Nach dem Aufbringen der Passivierungsschicht 8 bedeckt diese die Seitenfläche 11 der Ausnehmung 10 auch im Bereich der die Hinterschneidung 13 bildenden Unterätzung unmittelbar unterhalb der zweiten Maskenschicht 5, also am Rand der Ausnehmung 10, vollständig. Die Passivierungsschicht 8 weist ein elektrisch isolierendes Material auf, beispielsweise ein Oxid oder Oxinitrid wie etwa Siliziumdioxid oder Siliziumoxinitrid. Insbesondere kann die Passivierungsschicht 8 auch ein gleiches Material wie die zweite Maskenschicht aufweisen.

In Figur 2E ist ein weiterer Verfahrensschritt gezeigt, bei dem die Passivierungsschicht 8 selektiv von der dem Halbleiterkörper 1 abgewandten Seite der zweiten Maskenschicht 6, von der Bodenfläche 12 der zumindest einen Ausnehmung 10 und von der in der Ausnehmung 10 angeordneten Kontaktschicht 7 entfernt wird, so dass die Passivierungsschicht 8 im Bereich der Unterätzung beziehungsweise Hinterschneidung 13 auf der Seitenfläche 11 der zumindest einen Ausnehmung 10 zumindest teilweise, besonders bevorzugt auf der gesamten Seitenfläche 11, verbleibt. Die Passivierungsschicht 8 kann von der Bodenfläche 12 und der Kontaktschicht 7 beispielsweise derart entfernt werden, dass die Passivierungsschicht 8 im Bereich der Bodenfläche 12 der zumindest einen Ausnehmung 10 an die Kontaktschicht 7 anschließt. Zum Entfernen der Passivierungsschicht 8 wird insbesondere ein gerichtetes Rückätzverfahren 99 verwendet, wie durch die in Figur 2E gezeigten Pfeile angedeutet ist. Das Rückätzverfahren 90 kann großflächig und ohne Einsatz einer zusätzlichen Maske erfolgen, da die zweite Maskenschicht 6 die erforderliche Abschattung der Seitenfläche 11 der zumindest einen Ausnehmung 10 im Halbleiterkörper 1 gewährleistet. Das gerichtete Ätzverfahren 90 kann beispielsweise ein trockenchemisches Ätzverfahren sein, bei dem ein Fluorhaltiges Gas, insbesondere ein Fluor-Plasma verwendet wird. Besonders bevorzugt verbleibt die Passivierungsschicht 8 nach dem Rückätzverfahren 99 ausschließlich zumindest teilweise auf der Seitenfläche 11 der zumindest einen Ausnehmung 10 im Halbleiterkörper 1.

Dadurch, dass die Herstellung der zweiten Maskenöffnung 60 in der zweiten Maskenschicht 6, die denjenigen Bereich der Ausnehmung 10 definiert, in dem die Kontaktschicht 7 aufgebracht und später die Passivierungsschicht 8 wieder entfernt wird, und die Herstellung der Ausnehmung 10 selbst in einen gemeinsamen Verfahrensschritt zusammengelegt wird, erfolgt die Ausbildung der zweiten Maskenöffnung 60 relativ zur Ausnehmung 10 in einem selbstjustierenden Prozess. Die definierte Unterätzung der zweiten Maskenschicht 6 stellt im Vergleich zu einer separat hergestellten Maske eine deutlich vereinfachte Prozessführung und damit eine Kostenreduktion im Vergleich zu bekannten Verfahren dar.

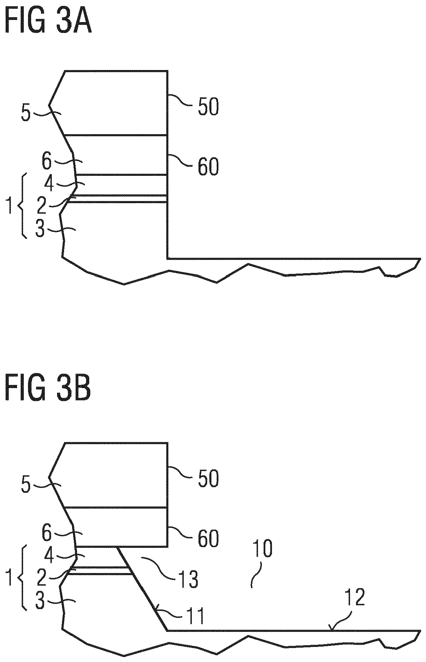

Die Herstellung der zweiten Maskenöffnung 60 und der Ausnehmung 10 kann auch in einem mehrstufigen Ätzverfahren durchgeführt werden, wie in Verbindung mit den Figuren 3A und 3B gezeigt ist. Hierzu kann beispielsweise die Ausbildung der zumindest einen zweiten Maskenöffnung 60 in der zweiten Maskenschicht 6 mittels eines ersten Ätzverfahrens erfolgen. Hierbei kann es sich beispielsweise bei der Verwendung eines Oxids oder Oxinitrids als Material für die zweite Maskenschicht 6 um ein trockenchemisches Ätzverfahren handeln. Wie in Figur 3A erkennbar ist, kann durch ein derartiges Ätzverfahren auch bereits ein Bereich des Halbleiterkörpers 1 entfernt werden. Mittels eines zweiten Ätzverfahrens kann die gegebenenfalls endgültige Ausbildung der zumindest einen Ausnehmung 10 im Halbleiterkörper 1 erfolgen. Insbesondere kann durch das zweite Ätzverfahren, das beispielsweise ein nasschemisches Ätzverfahren sein kann, die Hinterschneidung 13 durch eine Unterätzung der zweiten Maskenschicht 6 im Bereich des Rands der zweiten Maskenöffnung 60 erfolgen.

Ein derartiges mehrstufiges Ätzverfahren kann beispielsweise in Verbindung mit einem Halbleiterkörper 1, der auf einem InAlGaN-Verbindungshalbleitermaterial basiert, vorteilhaft sein, da es bei diesem Materialsystem möglich sein kann, dass eine rein nasschemische Ätzung von Ga-polaren Oberflächen nur schwer möglich ist. Ausgehend von einer trockengeätzten Öffnung 60 in der zweiten Maskenschicht 6 und gegebenenfalls auch eines Bereichs im Halbleiterkörper 1 kann aber durch eine zusätzliche nasschemische Ätzung die für das weitere Verfahren erforderliche Hinterschneidung 13 erzeugt werden.

Bei nitridischen Verbindungshalbleitermaterialsystemen, also einem Halbleiterkörper auf Basis von InAlGaN, kann die Ätzwirkung eines nasschemischen Ätzverfahrens abhängig von der zu ätzenden Kristallfläche sein. In diesem Fall kann es vorteilhaft sein, wenn die Maskenöffnungen 50, 60 und entsprechend die Ausnehmung 10 eine sechseckige Form aufweisen.

An den in Figur 3B gezeigten Verfahrensschritt können sich die weiteren in Verbindung mit den Figuren 2C und 2D beschriebenen Verfahrensschritte anschließen.

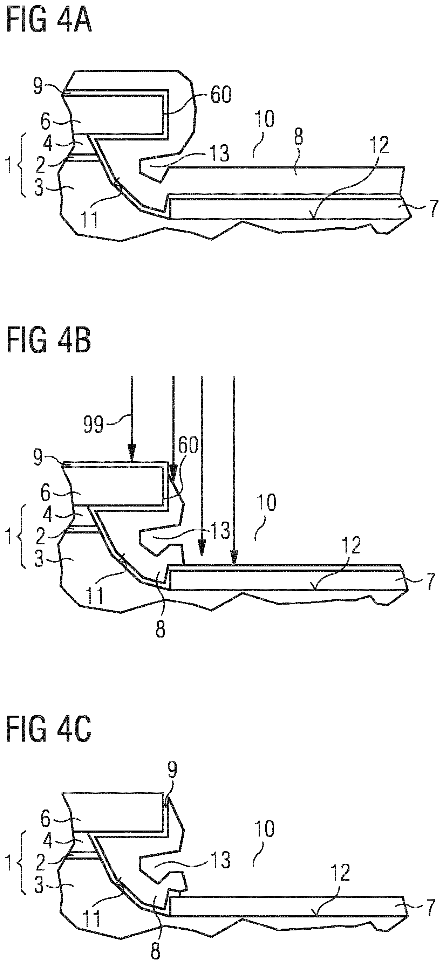

In Verbindung mit den Figuren 4A bis 4C ist ein weiteres Ausführungsbeispiel für Verfahrensschritte eines Verfahrens zur Herstellung eines Halbleiterkörpers 1 mit zumindest einer mit einer Kontaktschicht 7 versehenen Ausnehmung 10 beschrieben. Den in Verbindung mit den Figuren 4A bis 4C beschriebenen Verfahrensschritten gehen die in Verbindung mit den Figuren 2A bis 2C und gegebenenfalls die in Verbindung mit den Figuren 3A und 3B beschriebenen Verfahrensschritte voraus, so dass die in Verbindung mit der Figur 4A beschriebenen Verfahrensschritte unmittelbar an das Entfernen der ersten Maskenschicht 5 mit der darauf aufgebrachten Kontaktschicht 7 anschließen.

Wie in Figur 4A gezeigt ist, wird in einem weiteren Verfahrensschritt großflächig auf allen freiliegenden Oberflächen der zweiten Maskenschicht 6, der zumindest einen Ausnehmung 10 im Halbleiterkörper 1 und der Kontaktschicht 7 in der Ausnehmung 10 eine Ätzstoppschicht 9 aufgebracht. Hierzu kann beispielsweise ein vorab in Verbindung mit der Passivierungsschicht 8 beschriebenes Verfahren verwendet werden. Über der Ätzstoppschicht 9 wird wie in Verbindung mit den vorherigen Verfahren beschrieben großflächig die Passivierungsschicht 8 aufgebracht, so dass die Ätzstoppschicht 9 vollständig von der Passivierungsschicht 8 überdeckt ist.

In einem weiteren Verfahrensschritt wird, wie in Figur 4B gezeigt ist, mittels des vorab beschriebenen gerichteten Rückätzverfahrens 99 selektiv die Passivierungsschicht 8 auf der dem Halbleiterkörper 1 abgewandten Seite der zweiten Maskenschicht 6, auf der Bodenfläche 12 der Ausnehmung 10 und auf der Kontaktschicht 7 in der Ausnehmung 10 entfernt, so dass aufgrund der Hinterschneidung 13 auf der Seitenfläche 11 der Ausnehmung 10 die Passivierungsschicht 8 verbleibt. Die Ätzstoppschicht 9 kann beispielsweise Aluminiumoxid aufweisen oder daraus bestehen. Durch Fluor-haltige Gase, die beim trockenchemischen Ätzen der zweiten Maskenschicht 6 oder der Passivierungsschicht 8 verwendet werden können, wird die Ätzstoppschicht 9 dann nur sehr langsam angegriffen. Durch die Ätzstoppschicht 9 werden die darunter liegenden Schichten während des gerichteten Rückätzverfahrens 99 geschützt werden, so dass die Prozessführung entspannt werden kann. So kann insbesondere im Vergleich zu einem Verfahren ohne Ätzstoppschicht länger überätzt werden, ohne in das Problem zu laufen, dass die zweite Maskenschicht 6 und/oder die Kontaktschicht 7 geschädigt oder durchgeätzt werden.

In einem weiteren Verfahrensschritt kann, wie in Figur 4C gezeigt ist, die Ätzstoppschicht 9 auf der dem Halbleiterkörper 1 abgewandten Seite der zweiten Maskenschicht 6, auf der Bodenfläche 12 der Ausnehmung 10 und auf der Kontaktschicht 7 in der Ausnehmung 1 entfernt werden. Zur selektiven Entfernung der Ätzstoppschicht 9 kann sich bei der Verwendung von Aluminiumoxid als Material für die Ätzstoppschicht 9 beispielsweise Phosphorsäure eignen.

Dadurch, dass die Ätzstoppschicht 9 unterhalb der Passivierungsschicht 8 angeordnet ist, verbleibt diese auf der Seitenfläche 11 der zumindest einen Ausnehmung 10 zusammen mit der Passivierungsschicht 8 und bildet somit einen Teil der Passivierung der Seitenfläche 11 der zumindest einen Ausnehmung 10.

Die mit den vorab beschriebenen Verfahren auf der Seitenfläche 11 der zumindest einen Ausnehmung 10 im Halbleiterkörper 1 hergestellte Passivierungsschicht 8, und gegebenenfalls auch die Ätzstoppschicht 9, bildet zusammen mit der auf dem Halbleiterkörper 1 verbleibenden zweiten Maskenschicht 6 eine Isolationsschicht wie beispielsweise die in Verbindung mit Figur 1 beschriebenen Isolationsschicht 113, die den Halbleiterkörper 1 zusammenhängend bis auf die Bodenfläche 12 der zumindest einen Ausnehmung 10, auf der die Kontaktschicht 7 aufgebracht ist, bedeckt.

Die in Verbindung mit den Figuren beschriebenen Ausführungsbeispiele können alternativ oder zusätzlich weitere oben im allgemeinen Teil beschriebene Merkmale aufweisen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet.

## Patentansprüche

1. Verfahren zur Herstellung eines Halbleiterkörpers (1) mit zumindest einer mit einer Kontaktschicht (7) versehenen Ausnehmung (10) mit den Schritten:
A) Bereitstellen des Halbleiterkörpers (1),
B) Aufbringen einer ersten Maskenschicht (5) und einer zweiten Maskenschicht (6) auf dem Halbleiterkörper (1), wobei die zweite Maskenschicht (6) unstrukturiert auf dem Halbleiterkörper (1) aufgebracht wird und die erste Maskenschicht (5) strukturiert mit zumindest einer ersten Maskenöffnung (50) auf der zweiten Maskenschicht (6) aufgebracht wird,
C) Ausbilden von zumindest einer zweiten Maskenöffnung (60) in der zweiten Maskenschicht (6) und zumindest einer Ausnehmung (10) im Halbleiterkörper (1) im Bereich der zumindest einen ersten Maskenöffnung (50) der ersten Maskenschicht (5), wobei die Ausnehmung (10) eine Seitenfläche (11) und eine Bodenfläche (12) aufweist und die Ausnehmung (10) mit der zweiten Maskenöffnung (60) von der ersten Maskenöffnung (50) aus gesehen eine Hinterschneidung (13) bildet,
D) Aufbringen einer Kontaktschicht (7) auf die erste Maskenschicht (5) und die Bodenfläche (12) der zumindest einen Ausnehmung (10) mittels eines gerichteten Abscheideverfahrens,
E) Aufbringen einer Passivierungsschicht (8) auf der Seitenfläche (11) der zumindest einen Ausnehmung (10).

2. Verfahren nach Anspruch 1, bei dem die Kontaktschicht (7) aufgedampft wird.

3. Verfahren nach einem der vorherigen Ansprüche, bei dem die Kontaktschicht (7) ein Metall und/oder ein transparentes leitendes Oxid aufweist.

4. Verfahren nach einem der vorherigen Ansprüche, bei dem der Verfahrensschritt E die folgenden Verfahrensschritte umfasst:
E1) Unstrukturiertes Aufbringen der Passivierungsschicht (8) auf der zweiten Maskenschicht (6), auf der Seitenfläche (11) und der Bodenfläche (12) der zumindest einen Ausnehmung (10) und auf der Kontaktschicht (7),
E2) Entfernen der Passivierungsschicht (8) von der dem Halbleiterkörper (1) abgewandten Seite der zweiten Maskenschicht (6), von der Bodenfläche (12) der zumindest einen Ausnehmung (10) und von der Kontaktschicht (7), wobei die Passivierungsschicht (8) auf der Seitenfläche (12) der zumindest einen Ausnehmung (10) zumindest teilweise verbleibt.

5. Verfahren nach Anspruch 4, bei dem Passivierungsschicht (8) im Verfahrensschritt E2 mittels eines gerichteten Rückätzverfahrens (99) entfernt wird.

6. Verfahren nach Anspruch 5, bei dem das gerichtete Rückätzverfahren (99) ein trockenchemisches Ätzverfahren ist.

7. Verfahren nach einem der vorherigen Ansprüche, bei dem die Passivierungsschicht (8) nach dem Verfahrensschritt E im Bereich der Bodenfläche (12) der zumindest einen Ausnehmung (10) an die Kontaktschicht (7) anschließt.

8. Verfahren nach einem der vorherigen Ansprüche, bei dem vor dem Verfahrensschritt E die erste Maskenschicht (5) mit der darauf aufgebrachten Kontaktschicht (7) entfernt wird.

9. Verfahren nach einem der vorherigen Ansprüche, bei dem die zweite Maskenschicht (6) nach dem Verfahrensschritt E auf dem Halbleiterkörper (1) verbleibt und zusammen mit der Passivierungsschicht (8) eine zusammenhängende Isolationsschicht bildet.

10. Verfahren nach einem der Ansprüche 1 bis 9, bei dem im Verfahrensschritt C die Ausbildung der zumindest einen zweiten Maskenöffnung (60) und der zumindest einen Ausnehmung (10) mittels eines gemeinsamen Ätzverfahrens erfolgt.

11. Verfahren nach Anspruch 10, bei dem das gemeinsame Ätzverfahren ein nasschemisches Ätzverfahren ist.

12. Verfahren nach einem der Ansprüche 1 bis 9, bei dem im Verfahrensschritt C die Ausbildung der zumindest einen zweiten Maskenöffnung (60) mittels eines ersten Ätzverfahrens und die Ausbildung der zumindest einen Ausnehmung (10) mittels zumindest eines zweiten Ätzverfahrens erfolgt.

13. Verfahren nach Anspruch 12, bei dem das erste Ätzverfahren ein trockenchemisches Ätzverfahren und das zweite Ätzverfahren ein nasschemisches Ätzverfahren ist.

14. Verfahren nach einem der vorherigen Ansprüche, bei dem der Halbleiterkörper (1) als Halbleiterschichtenfolge mit aufeinander angeordneten Halbleiterschichten (2, 3, 4) bereitgestellt wird und die erste Maskenschicht (5) auf einer Hauptoberfläche der Halbleiterschichtenfolge aufgebracht wird.

15. Verfahren nach einem der vorherigen Ansprüche, bei dem die zweite Maskenschicht und die Passivierungsschicht ein gleiches Material aufweisen.

16. Verfahren nach einem der vorherigen Ansprüche, bei dem zwischen den Verfahrensschritten D und E eine Ätzstoppschicht (9) auf der zweiten Maskenschicht (6), auf der Seitenfläche (11) und der Bodenfläche (12) der zumindest einen Ausnehmung (10) und auf der Kontaktschicht (7) großflächig aufgebracht wird.

17. Verfahren nach Anspruch 16, bei dem die Ätzstoppschicht (9) und die Passivierungsschicht (8) von der dem Halbleiterkörper (1) abgewandten Seite der zweiten Maskenschicht (6), von der Bodenfläche (12) der zumindest einen Ausnehmung (10) und von der Kontaktschicht (7) entfernt werden, wobei die Ätzstoppschicht (9) und die Passivierungsschicht (8) auf der Seitenfläche (11) der zumindest einen Ausnehmung (10) zumindest teilweise verbleiben.

18. Verfahren nach Anspruch 16 oder 17, bei dem die Ätzstoppschicht (9) Aluminiumoxid aufweist.

19. Verfahren nach einem der vorherigen Ansprüche, bei dem die zweite Maskenschicht (6) und/oder die Passivierungsschicht (8) Siliziumdioxid oder Siliziumoxidnitrid aufweisen.

20. Verfahren nach einem der vorherigen Ansprüche, bei dem die erste Maskenschicht (5) eine Lackmaske und/oder die zweite Maskenschicht (6) eine Hartmaske basierend auf einem Oxid oder Oxinitrid ist.

## Claims

1. Method for producing a semiconductor body (1) with at least one recess (10) provided with a contact layer (7), comprising the steps:
A) providing the semiconductor body (1),
B) applying a first mask layer (5) and a second mask layer (6) to the semiconductor body (1), wherein the second mask layer (6) is applied unpatterned to the semiconductor body (1) and the first mask layer (5) is applied patterned with at least one first mask opening (50) to the second mask layer (6),
C) forming at least one second mask opening (60) in the second mask layer (6) and at least one recess (10) in the semiconductor body (1) in the region of the at least one first mask opening (50) in the first mask layer (5), wherein the recess (10) comprises a side face (11) and a bottom face (12) and the recess (10) forms an undercut (13) with the second mask opening (60), when viewed from the first mask opening (50),
D) applying a contact layer (7) to the first mask layer (5) and the bottom face (12) of the at least one recess (10) using a directional deposition method,
E) applying a passivation layer (8) to the side face (11) of the at least one recess (10).

2. Method according to claim 1, wherein the contact layer (7) is evaporated on.

3. Method according to one of the preceding claims, wherein the contact layer (7) comprises a metal and/or a transparent conductive oxide.

4. Method according to one of the preceding claims, wherein method step E comprises the following method steps:
E1) applying the passivation layer (8) unpatterned to the second mask layer (6), to the side face (11) and the bottom face (12) of the at least one recess (10) and to the contact layer (7),
E2) removing the passivation layer (8) from the side of the second mask layer (6) remote from the semiconductor body (1), from the bottom face (12) of the at least one recess (10) and from the contact layer (7), wherein the passivation layer (8) remains at least in part on the side face (11) of the at least one recess (10).

5. Method according to claim 4, wherein the passivation layer (8) is removed in method step E2 using a directional etch back method (99).

6. Method according to claim 5, wherein the directional etch back method (99) is a dry chemical etching method.

7. Method according to one of the preceding claims, wherein, after method step E, the passivation layer (8) adjoins the contact layer (7) in the region of the bottom face (12) of the at least one recess (10).

8. Method according to one of the preceding claims, wherein, prior to method step E, the first mask layer (5) is removed together with the contact layer (7) applied thereto.

9. Method according to one of the preceding claims, wherein, after method step E, the second mask layer (6) remains on the semiconductor body (1) and forms a contiguous insulation layer together with the passivation layer (8).

10. Method according to one of claims 1 to 9, wherein, in method step C, the at least one second mask opening (60) and the at least one recess (10) are formed by means of a joint etching method.

11. Method according to claim 10, wherein the joint etching method is a wet chemical etching method.

12. Method according to one of claims 1 to 9, wherein, in method step C, the at least one second mask opening (60) is formed by means of a first etching method and the at least one recess (10) is formed by means of at least one second etching method.

13. Method according to claim 12, wherein the first etching method is a dry chemical etching method and the second etching method is a wet chemical etching method.

14. Method according to one of the preceding claims, wherein the semiconductor body (1) is provided as a semiconductor layer sequence with semiconductor layers (2, 3, 4) arranged one above the other and the first mask layer (5) is applied to a major surface of the semiconductor layer sequence.

15. A method according to one of the preceding claims, wherein the second mask layer and the passivation layer comprise the same material.

16. Method according to one of the preceding claims, wherein, between method steps D and E, an etch stop layer (9) is applied over a large area to the second mask layer (6), to the side face (11) and the bottom face (12) of the at least one recess (10) and to the contact layer (7).

17. Method according to claim 16, wherein the etch stop layer (9) and the passivation layer (8) are removed from the side of the second mask layer (6) remote from the semiconductor body (1), from the bottom face (12) of the at least one recess (10) and from the contact layer (7), wherein the etch stop layer (9) and the passivation layer (8) remain at least in part on the side face (11) of the at least one recess (10).

18. Method according to claim 16 or 17, wherein the etch stop layer (9) comprises aluminum oxide.

19. Method according to one of the preceding claims, wherein the second mask layer (6) and/or the passivation layer (8) comprise silicon dioxide or silicon oxynitride.

20. Method according to one of the preceding claims, wherein the first mask layer (5) comprises a resist mask and/or the second mask layer (6) is a hard mask based on an oxide or oxynitride.

## Revendications

1. Procédé destiné à la fabrication d'un corps de semiconducteur (1) avec au moins un creux (10) doté d'une couche de contact (7) avec les étapes de :
A) mise à disposition du corps de semiconducteur (1),
B) application d'une première couche de masque (5) et d'une seconde couche de masque (6) sur le corps de semiconducteur (1), sachant que la seconde couche de masque (6) est appliquée non structurée sur le corps de semiconducteur (1) et que la première couche de masque (5) est appliquée structurée avec au moins une première ouverture du masque (50) sur la seconde couche de masque (6),
C) formation d'au moins une seconde ouverture de masque (60) dans la seconde couche de masque (6) et d'au moins un creux (10) dans le corps de semiconducteur (1) dans la zone d'au moins l'une des premières ouvertures de masque (50) de la première couche de masque (5), sachant que le creux (10) présente une surface latérale (11) et une surface de fond (12) et que le creux (10) constitue une contre-dépouille (13) avec la seconde ouverture de masque (60), vu de la première ouverture de masque (50),
D) application d'une couche de contact (7) sur la première couche de masque (5) et la surface de fond (12) d'au moins l'un des creux (10) au moyen d'un procédé de séparation dirigé,
E) application d'une couche de passivation (8) sur la surface latérale (11) d'au moins l'un des creux (10).

2. Procédé selon la revendication 1, lors duquel la couche de contact (7) est déposée en phase vapeur.

3. Procédé selon une quelconque des revendications précédentes, lors duquel la couche de contact (7) présente un métal et/ou un oxyde conducteur transparent.

4. Procédé selon une quelconque des revendications précédentes, lors duquel l'étape de procédé E présente les étapes de procédé suivantes :
E1) application non structurée de la couche de passivation (8) sur la seconde couche de masque (6), sur la surface latérale (11) et la surface de fond (12) d'au moins l'un des creux (10) et sur la couche de contact (7),
E2) retrait de la couche de passivation (8) du côté détourné du corps de semiconducteur (1) de la seconde couche de masque (6), de la surface de fond (12) d'au moins l'un des creux (10) et de la couche de contact (7), sachant que la couche de passivation (8) reste au moins partiellement sur la surface latérale (12) d'au moins l'un des creux (10).

5. Procédé selon la revendication 4, lors duquel la couche de passivation (8) est ôtée à l'étape de procédé E2 au moyen d'un procédé de décapage dirigé (99).

6. Procédé selon la revendication 5, lors duquel le procédé de décapage dirigé (99) est un procédé de gravure chimique à sec.

7. Procédé selon une quelconque des revendications précédentes, lors duquel la couche de passivation (8) se joint à la couche de contact (7) après l'étape de procédé E dans la zone de la surface de fond (12) d'au moins l'un des creux (10).

8. Procédé selon une quelconque des revendications précédentes, lors duquel avant l'étape de procédé E, la première couche de masque (5) est ôtée avec la couche de contact (7) appliquée dessus.

9. Procédé selon une quelconque des revendications précédentes, lors duquel la seconde couche de masque (6) reste sur le corps de semiconducteur (1) après l'étape de procédé E et constitue une couche d'isolation cohérente ensemble avec la couche de passivation (8).

10. Procédé selon une quelconque des revendications 1 à 9, lors duquel, à l'étape de procédé C, la constitution d'au moins l'une des secondes ouvertures de masque (60) et d'au moins l'un des creux (10) est réalisée au moyen d'un procédé de gravure commun.

11. Procédé selon la revendication 10, lors duquel le procédé de gravure commun est un procédé de gravure chimique humide.

12. Procédé selon une quelconque des revendications 1 à 9, lors duquel, à l'étape de procédé C, la constitution d'au moins l'une des secondes ouvertures de masque (60) est réalisée au moyen d'un premier procédé de gravure et la constitution d'au moins l'un des creux (10) au moyen d'au moins un second procédé de gravure.

13. Procédé selon la revendication 12, lors duquel le premier procédé de gravure est un procédé de gravure chimique à sec et le second procédé de gravure un procédé de gravure chimique humide.

14. Procédé selon une quelconque des revendications précédentes, lors duquel le corps de semiconducteur (1) est mis à disposition comme succession de couches semiconductrices avec des couches semiconductrices (2, 3, 4) disposées les unes sur les autres et la première couche de masque (5) est appliquée sur une surface principale de la succession de couches semiconductrices.

15. Procédé selon une quelconque des revendications précédentes, lors duquel la seconde couche de masque et la couche de passivation présentent une même matière.

16. Procédé selon une quelconque des revendications précédentes, lors duquel, entre les étapes de procédé D et E est apposée sur une grande surface une couche d'arrêt de gravure (9) sur la seconde couche de masque (6), sur la surface latérale (11) et la surface de fond (12) d'au moins l'un des creux (10) et sur la couche de contact (7).

17. Procédé selon la revendication 16, lors duquel la couche d'arrêt de gravure (9) et la couche de passivation (8) sont retirées du côté détourné du corps de semiconducteur (1) de la seconde couche de masque (6), de la surface de fond (12) d'au moins l'un des creux (10) et de la couche de contact (7), sachant que la couche d'arrêt de gravure (9) et la couche de passivation (8) restent au moins partiellement sur la surface latérale (11) d'au moins l'un des creux (10).

18. Procédé selon les revendications 16 ou 17, lors duquel la couche d'arrêt de gravure (17) présente de l'oxyde d'aluminium.

19. Procédé selon une quelconque des revendications précédentes, lors duquel la seconde couche de masque (6) et/ou la couche de passivation (8) présentent du dioxyde de silicium ou du nitrure d'oxyde de silicium.

20. Procédé selon une quelconque des revendications précédentes, lors duquel la première couche de masque (5) est un masque de vernis et/ou la seconde couche de masque (6) un masque dur se basant sur un oxyde ou un nitrure d'oxyde.
